# EUROPEAN PATENT APPLICATION

(11) **EP 1 862 433 A1**
(43) Date of publication of application: **05.12.2007**
(21) Application number: 05790204.1
(22) Date of filing: 16.08.2005
(51) Int. Cl.: C01B 31/06, C30B 29/04

(54) **PERSONALISED SYNTHETIC DIAMOND OF DIFFERENT COLOURS, OBTAINED FROM (LIVING OR DEAD) HUMAN OR ANIMAL KERATIN AND PRODUCTION METHOD THEREOF**

(30) Priority: 21.02.2005 ES 200500389
(71) Applicant: Instituto De Monocristales, S.L., 41410 Carmona (ES)
(72) Inventor: MARTIN PARRONDO, Ramon, E-41410 Carmona (ES); BAGRIANTSEV, Dmitri, E-41410 Carmona (ES)
(74) Representative: ABG Patentes, S.L.
(86) International application number: PCT/ES2005/000464
(87) International publication number: WO 2006/082259

(57) **Abstract**

The present invention refers to the provision of a process to manufacture large diamond monocrystals of different colors from carbon obtained from the keratin contained in the ectoderm of many living beings being possible to extract carbon from a human being by cutting a lock of hair and carbonizing it, and then subjecting it to a high pressure high temperature process.

## Description

### OBJECT OF THE INVENTION

The present invention consists in obtaining large type Ib IIa and IIb synthetic diamond monocrystals from carbon found in those tissues or parts of the ectoderm which main component is the keratin protein, as well as the procedure for obtaining them by means of carbonization processes and methods that involve high pressures and high temperatures (HP HT).

### STATE OF THE ART

Diamonds, the cubic crystalline form of carbon, were first synthesized in the 1950's from mineral carbon. Since then there have been many advances in the field of diamond monocrystal synthesis. These advances have propitiated the industrial use of diamonds based on their extraordinary physical and chemical properties.

Diamond is the hardest substance known to man, a property which together with its high thermal conductivity and chemical inertia makes it apt for precision machining applications, heat dissipation, surgical instruments, radiation detectors, and laser optics amongst multiple other applications.

However, its applications in jewellery and generally in luxury items have been historically restricted, The main restrictions for its use as gem were applied to the first synthetic diamonds, that were yellow and were seen with skepticism due to their artificial provenance, and therefore it is difficult for them to penetrate certain markets, since they are put in direct competition with many natural and synthetic stones, including natural diamonds.

On the other hand, diamonds exert, unquestionably, a strong attraction in the markets due to their exclusiveness and high price.

All living creatures and particularly human beings, fix carbon in their tissues from their environment by means of a complex system of biochemical reactions. This carbon is formed from many organic compounds (carbohydrates, fats, aminoacids, etc.), but in general, there are very few tissues from which said carbon, already fixed by the living being, can be extracted in the sufficient quantity without harming the living being or without engaging in a complex and excessively cumbersome process to extract the carbon.

Up to now, this had only been achieved from carbon obtained from the ashes of dead beings, by purifying the graphite in the ashes. This practice, however, can only have a limited commercial reach, since it is necessary to wait for the death and later incineration of the being of which a memento is desired in the form of a crystal. Also certain groups see the process as immoral, for instance, those groups that see the marketing of post-incineration products as objectionable.

### DESCRIPTION OF THE INVENTION

There is a natural protein called keratin that is part of many living beings, humans particularly, and mammals amongst others. This protein, that has a structural function, is easily detachable from the living being, without causing it any harm. Keratin is found, in humans, in hair, nails and skin, amongst other parts. The quantity of carbon contained in this protein is between 45 and 51% by weight, which together with its ease of extraction makes said protein an easy and affordable source of carbon.

In animals, keratin is found in the hair, hoofs, horns and other parts and in that manner it is possible to extract carbon from a human being by cutting a lock of hair and then carbonizing it. Once the carbon has been obtained we can subject it to a high pressure high temperature process to obtain a synthetic diamond, from the carbon of the person.

Therefore the object of the present invention is to obtain a synthetic diamond crystal, with the possibility of it being personalized based on being synthesized from the keratin found in human or animal hair, amongst other, obtaining a product with the characteristics la, lla, llb.

The obtaining process is based in the carbonization of keratin by means of different methods and once dried, it is subjected to the high pressure high temperature (HP HT) machine claimed in patent N° 200500387 by the same author, as well as the reaction chamber protected by patent N° 200500386 by the same author, obtaining rough uncut synthetic diamond crystals.

The different keratin carbonization processes may be summed up in the following three methods:
• Method 1: by strong acid
• Method 2: by Bunsen burner, blowtorch or similar,
• Method 3: by Mufla oven

### DESCRIPTION OF THE DRAWINGS

Figure 1: Diagram of the functions of the complete process of carbonization by strong acid.
Figure 2: Diagram of the functions of the complete process of carbonization by Mufla oven.

### METHOD TO OBTAIN THE PREFERRED EMBODIMENT OF THE INVENTION

The method to obtain synthetic diamonds is based in obtaining carbon by carbonizing keratin with the different methods proposed by this invention, together with the application of said carbon in the high pressure high temperature machine and in the corresponding reaction chamber, all of them as indicated above, protected by patents by the same author. In this manner a personalized synthetic diamond can be obtained.

The carbonization processes that can be used are:

### Strong acid method:

The stages of this method are:
1. the hair or keratin-containing sample (pressed or not) is macerated in an excess of hot strong acid (normally boiling between 5 and 20 minutes, and generally during no more than 60 minutes). The strong acid may be H₂SO₄, HCl or any other acid or mixture of strong acids that do not oxidize the carbon during the process.
2.
   2.1. The acid is neutralized or diluted until obtaining a slightly acidic solution.
   2.2. The acid is used without neutralization - concentrated.
3. the carbon from the neutralized or slightly acidic solution is separated by:
   3.1. decanting
   3.2. filtering
   3.3. centrifuging
4. washing
5. drying

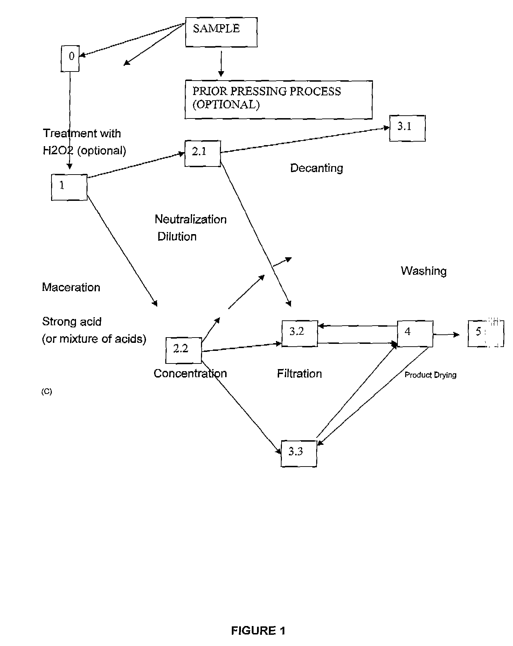

All stages are depicted in the diagram that outlines all the functions of the complete process shown in Figure 1.

**Example:** calculating the yield of the sulphuric acid concentration of 96% (as a function of time) for the total carbonization of the sample will determine the minimum amount of 96% H₂SO₄ necessary to completely carbonize the sample or objective in a time not to exceed 60 minutes.

### The results thus obtained are:

**A: 100% dilution of H₂SO₄ (96%)**

24 mL of H₂SO₄ are taken with a 25mL graduated pipette and 1 mL of distilled water are taken with the 10 mL graduated pipette.
5 discs of pressed human hair are prepared (a total of approximately 1.2 g) of 14 mm diameter and are added to the dilution in a 100 mL precipitation flask that is then heated during 15 minutes in a 500 to 1000 W electrical plate. The last step is to introduce a glass rod to make sure there are no remnants of undissolved sample.

This step is repeated with 80, 70 and 60% dilutions of H₂SO₄ (96%) using approximately the same amount of sample and the same heating time. The fifth step is done using HCl (16%) in the same conditions as those above.

The results of the first 4 processes are shown in the table below:

| **% H₂SO₄ (96%)** | **ml H₂SO₄** | **ml H₂O** | **Weight of the samples (g)** | | | | **Total weight (g)** |
|---|---|---|---|---|---|---|---|
| 100% | 24.0 | 1.0 | 0.413 | 0.313 | 0.279 | 0.217 | 1.222 |
| 80% | 19.2 | 5.8 | 0.275 | 0.393 | 0.252 | 0.352 | 1.272 |
| 70% | 16.8 | 8.2 | 0.399 | 0.307 | 0.300 | 0.287 | 1.293 |
| 60% | 14.4 | 10.6 | 0.374 | 0.324 | 0.347 | 0.212 | 1.257 |

The dry residue thus obtained is between 10 and 25% by weight of which, on average, 39.85% of the weight is free carbon after treatment with chromic mixture.

### Mufla oven method

This method has the following steps:
1. The hair or keratin-containing sample (pressed or not) is introduced in a mullite crucible or a crucible of any other refractory material with a gas outlet. This outlet must prevent, or at least obstruct, the entry of additional oxygen when the sample to carbonize is placed in the crucible, to avoid carbon oxidation.
2. The temperature is raised until attaining carbonization of the sample (between 500° C and 1500 ° C). In ovens with reducing atmospheres and graphite (or other type) crucibles the heating process may be continued obtaining the conversion of carbon or the graphite form (between 1800 and 3000 ° C). The graphite is recovered by means of:
   3.1. Mechanical process of dry scraping
   3.2. Wet scraping followed by dry scraping
4. Drying

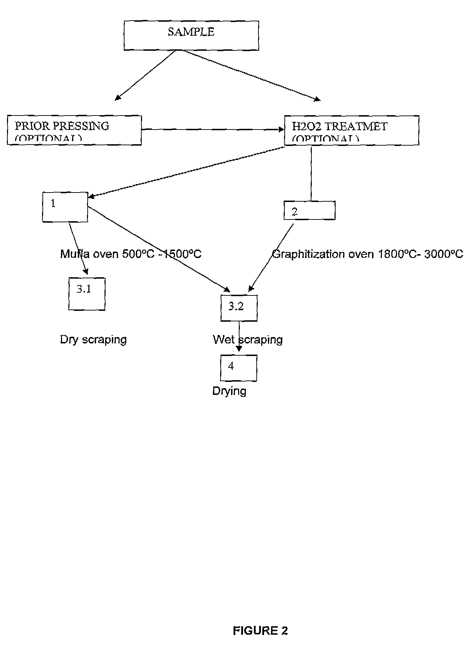

All the steps of this process are depicted in the diagram shown in Figure 2.

Example: below there are the data of the experiment done to obtain the carbonization of the target sample by heating.

**First Experience, Sample H1:** the sample (human hair) is placed in a 100 mL precipitation flask left uncovered and carbonization is done until reaching a 500 °C temperature. The data for this first experience is:
• Initial weight of the sample, H1: 0.986 g
• Final weight of the sample, H1: 0.186 g
• Loss: 0.800 g
• % loss: 81.13%
• % dry residue: 18.87%

After the treatment with chromic mixture, the following percentage of free carbon has been obtained: 43.99%.

**Second experience, Sample H2:** in this case the precipitation flask is covered with a diameter watch glass (sic) and at a temperature of also 500° C the following results are obtained:
• Initial weight of the sample, H2: 0.978 g
• Final weight of the sample, H2: 0,225 g
• Loss: 0.753 g
• % loss: 77%
• % dry residue: 23%

After the treatment with chromic mixture, the following percentage of free carbon has been obtained: 39.38%.

**Third experience, Sample H3**: 4 discs of human hair are prepared as sample using a 13.9 mm mold of 60 mm diameter and are subjected to 25 bars pressure. The discs are then placed in 10 x65 mm mullite capsules. The carbonization temperature is of 500° and the weights of the discs are as follows:
1. 0.241 g
2. 0.234 g
3. 0.256 g
4. 0.334 g
   • Initial weight of the sample, H3: 1.065 g
   • Final weight of the sample, H3: 0.183 g
   • Loss: 0.882 g
   • % loss: 82.82%
   • % dry residue: 17.18%

After the treatment with chromic mixture, the following percentage of free carbon has been obtained: 34.36%.

**Fourth experience. Sample H4:** 4 discs of human hair are prepared as sample following the same procedure described in Experience 3. The carbonization temperature is of 600° and the weights of the discs are as follows:
5. 0.206 g
6. 0.282 g
7. 0.298 g
8. 0.215 g
   • Initial weight of the sample, H4: 1.001 g
   • Final weight of the sample, H4: 0.158 g
   • Loss: 0.843 g
   • % loss: 82.82%
   • % dry residue: 15.78%

After the treatment with chromic mixture, the following percentage of free carbon has been obtained: 37.11 %.

**Fifth experience, Sample H5:** 1 horse hair sample is prepared in a disc following the same procedure used in the fourth experience. The carbonization temperature is of 650° and the disc weighs 1.100 g.
• Final weight of the sample: 0,153 g
• % dry residue: 13,9%

After the treatment with chromic mixture, the following percentage of free carbon has been obtained: 35.5%.

**SUMMARY TABLE**

| **Magnitudes/ Sample N°** | **Oven temperature** | **Initial weight (g)** | **Final weight (g)** | **Dry residue (%)** |
|---|---|---|---|---|
| **H 1** | 500 | 0.986 | 0.186 | 18.87 |
| **H 2** | 500 | 0.978 | 0.225 | 23.00 |
| **H 3** | 500 | 1.065 | 0.183 | 17.18 |
| **H 4** | 600 | 1.001 | 0.158 | 15.78 |
| **H 5** | 650 | 1.100 | 0.153 | 13.90 |

### Bunsen burner, blowtorch or similar method

The steps of this method are described below:
1. The hair or keratin-containing sample (pressed or not) is placed in a distillation flask (or any other distillation vessel). The gas and vapor outlet may be or not fitted with a vapor trap. This arrangement must prevent, or at least obstruct the entry of additional oxygen in the flask at the moment of introducing the sample to be carbonized to prevent the oxidation of the carbon.
2. Heating is done by Bunsen burner or similar, preferably with reducing flame until attaining the complete carbonization of the sample. Oxyacetylene blowtorches provided the flask is substituted by a refractory container in which a greater temperature can be obtained.
3. The carbon is recovered:
   • Mechanically by dry scraping
   • Wet scraping followed by dry scraping

### Example: the carbonization of the target sample with a Bunsen burner carried out in the experiments yielded the following results:

Three parallel experiences have been carried out. Experience A is done with human hair using a round-bottomed flask fitted with an adaptor to introduce a trap with water. Experience B is done with human hair in a distillation flask adapted with a Teflon stopper. Experience C is done in the same manner as experience B with animal (dog) hair instead. The dry residue is treated with a chromic mixture in order to eliminate the non-reactive organic matter residues. The percentage by weight of carbon is obtained after treating it with the chromic mixture and washing it afterwards.

| **Samples A** | **Initial Weight (g)** | **Final weight (g)** | **Time (min)** |
|---|---|---|---|
| **A1** | 0.688 | 0.155 | 4.26 |
| **A2** | 1.144 | 0.180 | 10 |
| **A3** | 0.837 | 0.146 | 10 |
| | | | |

| **Samples B** | **Initial Weight (g)** | **Final weight (g)** | **Time (min)** |
|---|---|---|---|
| **B1** | 0.777 | 0.109 | 5.30 |
| **B2** | 0.968 | 0.212 | 10 |
| **B3** | 0.781 | 0.112 | 10 |

• Samples 1 are prepared by weighing the indicated amounts of hair directly on the precision scale
• Samples 2 are prepared by making 14mm diameter discs subjected to 20 bars pressure in all cases. To obtain about 1 g of sample 4 discs are made. The discs' weights are the following:

| **DISCS** | **Sample WEIGHT A2 (g)** | **Sample WEIGHT B2 (g)** | **Sample WEIGHT A3(g)** | **Sample WEIGHT B3 (g)** |
|---|---|---|---|---|
| 1 | 0.233 | 0.508 | 0.183 | 0.211 |
| 2 | 0.279 | 0.460 | 0.236 | 0.246 |
| 3 | 0.248 | - | 0.219 | 0.170 |
| 4 | 0.384 | - | 0.199 | 0-154 |
| TOTAL | 1.144 | 0.968 | 0.837 | 0.781 |

**Summary table**

| **Samples** | **Time (min)** | **Initial weight 8g)** | **Final weight (g)** | **% loss** | **% dry residue** | **% free carbon** |
|---|---|---|---|---|---|---|
| **A1** | 4.26 | 0.688 | 0.155 | 77.47 | 22.53 | 44.09 |
| **B1** | 5.30 | 0.777 | 0.109 | 84.97 | 14.03 | 42.36 |
| **A2** | 10 | 1.144 | 0.180 | 84.26 | 15.74 | 41.86 |
| **B2** | 10 | 0.968 | 0.212 | 78.10 | 21.09 | 37.76 |
| **A3** | 10 | 0.837 | 0.146 | 82.56 | 17.44 | 42.08 |
| **B3** | 10 | 0.781 | 0.122 | 85.66 | 14.34 | 39.67 |
| **C1** | 10 | 1.115 | 0.151 | 86.87 | 13.13 | 32.47 |

The next step is to prepare several high pressure high temperature reaction capsules in which the source of carbon is the carbon obtained by the previously described procedures. Said capsules are then subjected to the high pressure high temperature capsules claimed in patents N° 200500386 and N° 200500387. The results thus obtained are:
For the growth of type 1b yellow crystals the following parameters are used: the temperature gradient is adjusted between 10 and 50° C and all the crystals are characterized by being of the color yellow and having an octahedral or octahedral cube shape. The nitrogen concentration is between 50 and 150 parts per million and the metal inclusions are concentrated in the initial seed area. Table I below shows the results:

**Table I**

| | **Example 1** | **Example 2** | **Example 3** |
|---|---|---|---|
| **Synthesis Pressure (GPa)** | 5.0 | 5.0 | 5.0 |
| **Temperature (°C)** | 1360 | 1360 | 1360 |
| **Solvent** | Fe-65 Ni | Fe-65 Ni | Fe-65 Co |

| **composition (% weight)** | | | |
|---|---|---|---|
| **Time (h)** | 85 | 41 | 80 |
| **Growth Speed rate (mg/h)** | 8.2 | 12.2 | 10 |
| **Weight of the diamond crystal (carats)** | 3.50 | 2.5 | 4 |
| **Metallic inclusions** | Lower part | Lower part | Lower part |

The following parameters are used to grow type IIa white or slightly colored crystals:
The temperature gradient is adjusted between 10 and 40° C. The color of the diamond crystal is adjusted by the thickness H of the membrane and the quantity of scavenger present in the mixture. Crystals 4.5 carats in weight and different colorations have been obtained. There are metallic inclusions in all the crystals around the seed area. Said inclusions do not prevent their commercial application. Table 2 below shows the results:

**Table 2**

| | **Example 4** | **Example 5** | **Example 6** |
|---|---|---|---|
| **Solvent composition (% weight)** | Fe-60 Co | Fe-60 Co | Fe-60 Co |
| **Time (h)** | 71 | 111 | 50 |
| **Weight of diamond crystal (carats)** | 3.5 | 4.5 | 1.00 |
| **Scavenger % by weight** | 2.0 % Ti | 10.0% Ti | 15% Ti |
| **Membrane thickness** | 0.25 | 0.3 | 0.3 |
| **** GIA color scale** | L | J | I |

To grow type IIb blue crystals the temperature gradient is adjusted between 10 and 30° C and the color of the diamond crystals is regulated by thickness H of the membrane and the quantity of scavenger present in the mixture. Titanium and Aluminum have been used as scavengers. About 1 to 60 ppm of Boron is introduced in the solvent metal. Crystals of different blue colors are obtained. Table 3 below shows the results:

**Table 3**

| | **Example 7** |
|---|---|
| **Composition of the solvent (% by weight)** | Fe-65 Co |
| **Scavenger % by weight** | 15.0 Ti |
| **Time (h)** | 170 |
| **Weight of diamond crystal (carats9** | 2.2 |
| **Boron (ppm)** | 20 |
| **Color** | blue |

## Claims

1. Synthetic diamond, of different colors, personalised from human or animal (alive or dead) keratin. Method of manufacture thereof, **characterized in that** the provenance of the carbon from which the synthetic diamond is formed, is the carbonization of the human or animal keratin, or of the tissues and parts which main organic component is keratin.

2. Synthetic diamond, of different colors, personalised from human or animal (alive or dead) keratin. Method of manufacture thereof according to Claim 1, **characterized in that** the carbon involved has been obtained by strong acid carbonization, Bunsen burner, blowtorch or similar and Mufla oven.

3. Synthetic diamond, of different colors, personalised from human or animal (alive or dead) keratin. Method of manufacture thereof according to Claim 1, **characterized in that** the strong acid method has the following stages:
1. The hair or keratin-containing sample (pressed or not) is macerated in an excess of hot strong acid (normally boiling) between 5 and 20 minutes.
2.
2.1 The acid is neutralized or diluted until obtaining a slightly acidic solution.
2.2 The acid is used without neutralization - concentrated.
3. The carbon from the neutralized or slightly acidic solution is separated by decanting filtering or centrifuging
4. Washing
5. Drying

4. Synthetic diamond, of different colors, personalised from human or animal (alive or dead) keratin, Method of manufacture thereof according to Claim 2 **characterized in that** the Mufla oven method has been used in the following sequence:
• The hair or keratin-containing sample (pressed or not) is introduced in a mullite crucible or a crucible of any other refractory material with a gas outlet. This outlet must prevent, or at least obstruct, the entry of additional oxygen when the sample to be carbonized is placed in the crucible to avoid carbon oxidation.
• The temperature is raised until attaining carbonization of the sample (between 500° C and 1500 °C). In ovens with reducing atmospheres and graphite (or other type) crucible the heating process may be continued obtaining the conversion of carbon or the graphite form (between 1800 and 3000 ° C). The graphite is recovered by means of:
• Mechanical process of dry scraping
• Wet scraping followed by dry scraping

5. Synthetic diamond, of different colors, personalised from human or animal (alive or dead) keratin. Method of manufacture thereof according to Claim 2 **characterized in that** the Bunsen burner method has been used in the following sequence:
• The hair or keratin-containing sample (pressed or not) is placed in a distillation flask (or container). The gas or vapor outlet may be with or without vapor trap. This arrangement must prevent or at least obstruct the entry of additional oxygen to the existing oxygen when the sample is introduced in the container to be carbonized. In this manner carbon oxidation is prevented.
• The Bunsen burner or similar is heated preferably with the reducing flame until attaining total carbonization of the sample. Oxyacetylene or hydrogen torches may also be used provided the flask is substituted by refractory containers in which a greater temperature can be obtained.
• The carbon is recovered by:
i. Mechanical process of dry scraping
ii. Wet scraping followed by dry scraping

6. Synthetic diamond, of different colors, personalised from human or animal (alive or dead) keratin. Method of manufacture thereof according to the previous claims and **characterized in that** the source of carbon obtained is subjected in the reaction capsules and the multi-anvil machine, as claimed in the patent registries N°200500386 and N° 200500387 by the same author, to a high pressure high temperature process, obtaining thus the synthetic diamond crystals Ib, IIa and IIb by the temperature gradient method of diamond growth.

7. Synthetic diamond, of different colors, personalised from human or animal (alive or dead) keratin. Method of manufacture thereof according to Claim 6 and **characterized in that** it uses the following parameters for the growth of type Ib yellow crystals:
The temperature gradient is adjusted between 10° and 50° and all the crystals are **characterized by** their yellow color and having an octahedral crystal structure or cubeoctahedron, the nitrogen concentration is between 50 and 150 parts per million and the metallic inclusions are concentrated in the area of the initial seed, with a diamond crystal weight (carat) between 2.5 and 4.

8. Synthetic diamond, of different colors, personalised from human or animal (alive or dead) keratin. Method of manufacture thereof according to Claim 6 **characterized in that** the following parameters are used to grow slightly colored or white type IIa crystals:
The temperature gradient is adjusted between 10° and 40°. The color of the diamond crystals is regulated by means of the thickness of the H membrane and the amount of scavenger present in the mixture.
Crystals of up to 4.5 carats in weight and different colorations have been obtained. There are metallic inclusions in all the crystals in the seed area. Said inclusions do not prevent their commercial application, (diamond crystals weighing between 1.00 and 4.5 carats having been obtained).

9. Synthetic diamond, of different colors, personalised from human or animal (alive or dead) keratin. Method of manufacture thereof according to Claim 6 and **characterized in that** to grow type IIb blue crystals the temperature gradient is adjusted between 10° and 30°. The color of the diamond crystals is regulated by means of the thickness of the H membrane and the amount of scavenger present in the mixture. Titanium and Aluminum have been used as scavengers. Between 1 and 60 ppm of Boron are introduced in the solving metal and crystals of various blue colors are obtained, the diamond crystals weighing 2.2 carats.
